(19) Europäisches Patentamt
European Patent Office
Office européen des brevets

(11) **EP 3 093 634 B1**

(12) **FASCICULE DE BREVET EUROPEEN**

(45) Date de publication et mention
de la délivrance du brevet:
**05.08.2020 Bulletin 2020/32**

(51) Int Cl.:
***G01J 1/42*** *(2006.01)*     *G01J 3/28* *(2006.01)*

(21) Numéro de dépôt: **16169087.0**

(22) Date de dépôt: **11.05.2016**

(54) **DETECTEUR OPTIQUE A SURFACE DE DETECTION COURBE**

OPTISCHER DETEKTOR MIT GEKRÜMMTER DETEKTIONSFLÄCHE

OPTICAL SENSOR WITH CURVED DETECTION SURFACE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.05.2015 FR 1554316**

(43) Date de publication de la demande:
**16.11.2016 Bulletin 2016/46**

(73) Titulaires:
 • **Commissariat à l'Energie Atomique et aux Energies Alternatives**
   **75015 Paris (FR)**
 • **Centre National de la Recherche Scientifique**
   **75016 Paris (FR)**

(72) Inventeurs:
 • **GAEREMYNCK, Yann**
   **73220 AIGUEBELLE (FR)**
 • **HUGOT, Emmanuel**
   **13006 MARSEILLE (FR)**
 • **FENDLER, Manuel**
   **57000 Metz (FR)**

(74) Mandataire: **Brevalex**
   **56, Boulevard de l'Embouchure**
   **B.P. 27519**
   **31075 Toulouse Cedex 2 (FR)**

(56) Documents cités:
**US-B1- 6 791 072**

EP 3 093 634 B1

**Description**

**DOMAINE TECHNIQUE**

La présente invention concerne un détecteur optique courbé, utilisé notamment pour compenser certains défauts d'un système optique d'imagerie disposé en amont.

**ÉTAT DE LA TECHNIQUE ANTÉRIEURE**

On connaît dans l'art antérieur différents procédés d'obtention d'un détecteur optique courbe, dont la courbure est destinée à compenser des aberrations optiques d'un système d'imagerie situé en amont. Dans tout le texte, le terme « courbure » désigne une déformation, et pas uniquement l'inverse d'un rayon de courbure.

Le document US-6,849,843 décrit un exemple d'un tel procédé. Une puce de silicium est collée sur un substrat flexible à l'aide d'une couche de colle. La couche de colle présente une très faible épaisseur, typiquement de l'ordre de 1 à 2 $\mu$m. On s'assure ainsi que la forme de la puce de silicium suit au plus près la forme du substrat flexible. Le substrat flexible est collé à son tour sur un support rigide.

Un autre exemple de l'état de la technique est fourni par le document US6791072 B1.

Un objectif de la présente invention est d'améliorer les dispositifs et procédés connus. Il s'agit en particulier d'améliorer les capacités de déformation des détecteurs optiques courbés connus.

**EXPOSÉ DE L'INVENTION**

Cet objectif est atteint avec un détecteur optique à surface de détection courbe comprenant :

- un capteur photosensible ;
- un support agencé pour imposer une courbure au capteur photosensible ; et
- une couche de colle, disposée directement entre le capteur photosensible et le support, et présentant une épaisseur supérieure ou égale à 50 $\mu$m.

Il a en effet pu être observé qu'une grande épaisseur de colle entre le capteur photosensible et le support permet, de façon surprenante, de réduire les contraintes imposées au capteur, à rayon de courbure égal.

Les préjugés de l'homme du métier l'incitent au contraire à limiter au maximum l'épaisseur de cette couche de colle. Or, il a été remarqué que ces faibles épaisseurs ont pour inconvénient de limiter la déformation maximale que l'on peut imposer au capteur sans le dégrader.

De préférence, la couche de colle présente une épaisseur comprise entre 50 $\mu$m et 150 $\mu$m, les bornes étant incluses.

La couche de colle (200) présente avantageusement un module d'Young compris entre 20 et 80 MPa, les bornes étant incluses.

Le capteur photosensible peut comprendre un substrat en matériau semiconducteur, au contact direct de la couche de colle.

Le substrat est avantageusement du silicium.

De préférence, un rapport entre une largeur du capteur photosensible, et un rayon de courbure du capteur photosensible, est supérieur ou égal à $\frac{1}{8}$.

Un rapport entre une largeur du capteur photosensible, et une amplitude pic-vallée de la surface supérieure du capteur photosensible, peut être inférieur ou égal à 40.

Le détecteur optique selon l'invention peut comprendre des moyens de déformation du support, reliés à des moyens d'asservissement agencés pour piloter en temps réel les moyens de déformation du support.

L'invention concerne également un système optique d'imagerie comprenant un détecteur optique selon l'invention.

L'invention concerne également un procédé de fabrication d'un détecteur optique comprenant les étapes suivantes :

- collage d'un capteur photosensible sur un support, à l'aide d'une couche de colle, disposée directement entre le capteur photosensible et le support ;
- déformation du support, entraînant une déformation du capteur photosensible collé sur le support ;

la couche de colle utilisée présentant une épaisseur supérieure ou égale à 50 μm.

**BRÈVE DESCRIPTION DES DESSINS**

La présente invention sera mieux comprise à la lecture de la description d'exemples de réalisation donnés à titre purement indicatif et nullement limitatif, en faisant référence aux dessins annexés sur lesquels :

- la figure 1 illustre un détecteur optique selon l'invention ;
- la figure 2 illustre les contraintes dans un capteur en silicium en fonction du module d'Young et de l'épaisseur de la couche de colle ;
- la figure 3 illustre de manière schématique un procédé de fabrication d'un détecteur optique selon l'invention ; et
- les figures 4A et 4B représentent deux variantes d'un système d'imagerie et illustrent une utilisation avantageuse d'un détecteur optique selon l'invention.

**EXPOSÉ DÉTAILLÉ DE MODES DE RÉALISATION PARTICULIERS**

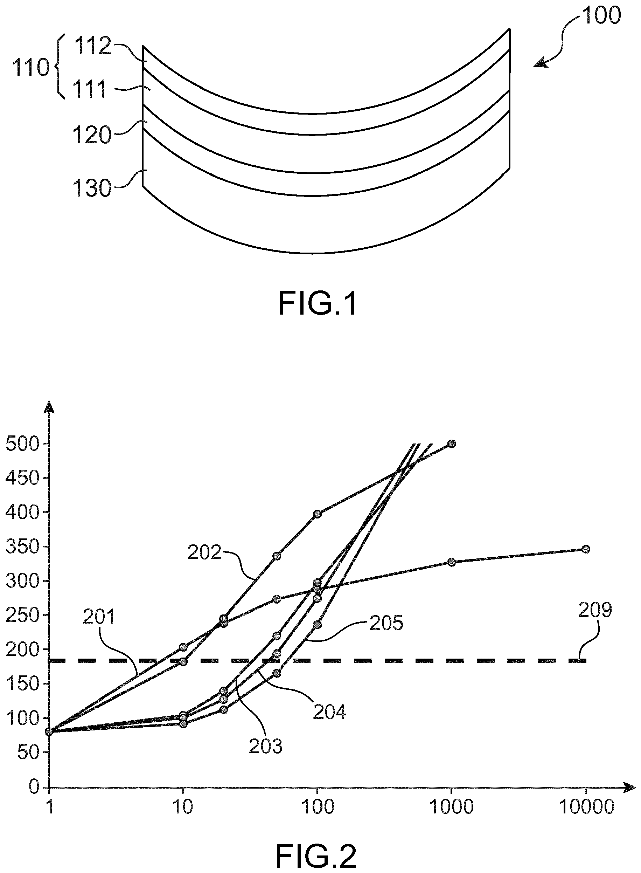

La figure 1 illustre un exemple de détecteur optique 100 selon l'invention. Le détecteur optique comprend un capteur photosensible 110, comprenant ici une couche dite active 112 intégrée sur un substrat en silicium 111. La couche active 112 comprend par exemple des électrodes. Des éléments, non représentés, tels que des filtres colorés ou des microlentilles peuvent être installés sur la couche active 112. La surface libre de la couche active comprend une partie dédiée à la détection de photons, et une partie dédiée à une électronique dite de lecture, permettant de comptabiliser les photons détectés. La surface de la couche active, dédiée à la détection de photons, est nommée surface de détection.
Le capteur 110 est un capteur photosensible connu, notamment un capteur CCD (pour *Charge-Coupled Device*) ou CMOS (pour *Complementarity metal-oxide-semiconductor*), et ne sera pas décrit plus amplement dans la suite.
Dans tout le texte, on considère l'exemple d'un capteur photosensible en silicium. Cependant, l'invention couvre aussi d'autres matériaux, notamment des matériaux semi-conducteurs tels que le sulfure de cadmium (CdS) ou le séléniure de cadmium (CdSe). En outre, l'invention n'est pas limitée à un capteur destiné à convertir un rayonnement électromagnétique en un signal électrique, mais couvre également un capteur de type bolomètre destiné à convertir un rayonnement électromagnétique en chaleur.
Le capteur photosensible est collé, de préférence du côté opposé à la couche active 112, sur un support 130. Ce collage est réalisé grâce à une couche de colle 120, disposée directement entre le capteur photosensible et le support.
La surface du support 130 située au contact de la couche de colle 120 présente une courbure connue. Du fait du collage, cette courbure est imposée au capteur photosensible 110, et notamment à la surface de détection. Cette courbure présente avantageusement par exemple une forme de conoïde, ou de portion de sphère, ou de portion de paraboloïde de révolution, ou une combinaison de ces surfaces, ces exemples n'étant pas limitatifs. Cette courbure est définie de préférence en fonction d'une ou plusieurs aberration(s) optique(s) d'un système d'imagerie, que l'on souhaite compenser par une forme adaptée du détecteur. De préférence, la surface de détection présente la forme d'une portion de sphère et permet de compenser un défaut de courbure de champ d'un système d'imagerie en amont du détecteur optique lorsque l'ordre 3 de la courbure de champ est prédominant.
Le support 130 est fait d'un matériau qui supporte la plastification par exemple en matière plastique (polymère) ou un métal tel que l'acier (par exemple de type AISI 420). Le support présente par exemple une épaisseur de 300 μm. La couche de colle 120 présente une épaisseur supérieure ou égale à 50 μm. L'épaisseur de la couche de colle est comprise de préférence entre 50 et 150 μm, les bornes étant incluses.
Cette grande épaisseur de la couche de colle permet de réduire les contraintes imposées au capteur, à courbure égale, et donc d'augmenter une déformation maximale du capteur photosensible (par exemple réduire le rayon de courbure minimal). On peut ainsi compenser des défauts importants d'un système d'imagerie situé en amont, comme détaillé dans la suite.
Lorsqu'il est courbé, le capteur photosensible est soumis à des contraintes liées à la courbure du capteur en elle-même, et des contraintes liées à l'absence de glissement du capteur 110 sur le support 130. On a pu monter qu'une grande épaisseur de la couche de colle permet de réduire les contraintes liées à l'absence de glissement du capteur 110 sur le support 130.
Le tableau ci-dessous détaille les résultats de plusieurs simulations numériques, obtenues en considérant un capteur photosensible en silicium, d'épaisseur 50 μm, de largeur 20 mm et de hauteur 10 mm. La simulation numérique considère la contrainte en sens de Von Mises :

$$\sigma_e = \frac{1}{\sqrt{2}}\sqrt{\left(\sigma_x - \sigma_y\right)^2 + \left(\sigma_y - \sigma_z\right)^2 + (\sigma_z - \sigma_x)^2}.$$

On suppose que le module d'Young de la couche de colle est le même dans chaque cas, par exemple 1 MPa. On détermine, pour plusieurs épaisseurs de la couche de colle, le rayon de courbure du capteur photosensible, lorsque l'on atteint la moitié de la limite d'élasticité de ce capteur. Cette limite d'élasticité vaut 180 MPa dans du silicium.

On rappelle que la limite d'élasticité est la contrainte à partir de laquelle un matériau arrête de se déformer d'une manière réversible et commence à se déformer de manière irréversible. Il s'agit ici plus particulièrement de la contrainte à partir de laquelle le capteur photosensible présente des changements sur la maille cristalline modifiant ses propriétés optoélectroniques ou des microfissures internes qui entraînent sa rupture.

Tableau 1

| Epaisseur de la couche de colle | 2μm | 10μm | 50μm | 80μm | 120μm |
|---|---|---|---|---|---|
| Rayon de courbure à la moitié de la limite d'élasticité | 294 mm | 177 mm | 166 mm | 158 mm | 163 mm |

On montre ainsi qu'augmenter l'épaisseur de la couche de colle permet de minimiser le plus petit rayon de courbure atteignable sans détériorer le capteur photosensible. En d'autres termes, on augmente la déformation maximale atteignable sans détériorer ce capteur.

Rien n'incitait l'homme du métier à jouer sur l'épaisseur de la couche de colle pour obtenir un tel résultat. Au contraire, il était admis que cette épaisseur devait être la plus fine possible, notamment afin de limiter les incertitudes sur le positionnement de chaque point de la surface de détection du détecteur optique. Néanmoins, l'invention ne nuit pas à la qualité de la compensation des défauts d'un système d'imagerie, car on a remarqué que dans ce contexte, on peut tolérer une certaine imprécision de positionnement de la surface de détection.

En outre, selon l'invention, le module d'Young de la couche de colle est avantageusement inférieur ou égal à 100 MPa. Il est compris de préférence entre 20 et 80 MPa inclus, par exemple 20 MPa. En pratique, on peut utiliser en tant que colle des matériaux commercialisés sous un autre nom, par exemple du joint silicone. On rappelle ici que le module d'Young est une constante associée à un matériau, qui relie une contrainte en traction appliquée au matériau à la déformation du matériau. Ce coefficient caractérise la raideur du matériau. On suppose que la couche de colle est réalisée dans un matériau isotrope. Le cas échéant, si ce matériau n'est pas isotrope, on définit un module d'Young pour chaque direction de l'espace, chacun de ces modules vérifiant la condition ci-dessus.

La figure 2 illustre différentes courbes des contraintes dans le capteur photosensible 110, en fonction du module d'Young de la couche de colle 120, pour différentes épaisseurs de la couche de colle 120, et à déformation égale. Dans chaque cas, le capteur photosensible présente une forme de portion de sphère, de rayon de courbure égal à 166 mm.

Les courbes 201, 202, 203, 204, 205 correspondent respectivement à une épaisseur de 2 μm, 10 μm, 50 μm, 80 μm et 120 μm. Elles sont obtenues par simulation numérique, comme décrit à propos du tableau 1.

La droite 209, en trait pointillé, représente la limite d'élasticité du matériau formant le capteur photosensible 110, ici le silicium.

On voit que pour une épaisseur de la couche de colle égale à 2 μm, seules des colles de très faible module d'Young permettent d'atteindre la déformation souhaitée tout en restant sous la limite d'élasticité. En particulier, pour une épaisseur de la couche de colle de 2 μm, le module d'Young de la colle doit être inférieur à 9 MPa.

Au fur et à mesure que cette épaisseur augmente, une plage de modules d'Young de plus en plus large permet d'atteindre la déformation souhaitée tout en restant sous la limite d'élasticité du capteur photosensible.

Ainsi, une épaisseur élevée de la couche de colle 120 permet de s'affranchir de toute condition drastique sur le module d'Young pour atteindre une déformation importante du capteur photosensible 110 tout en évitant de le détériorer.

Auparavant, l'homme du métier était incité à utiliser des colles à module d'Young élevé, par exemple supérieur à 150 MPa, afin de s'assurer d'un excellent maintien en position du capteur sur le support. Les mesures ci-dessus montrent qu'au contraire, il est plus avantageux de choisir des colles à module d'Young peu élevé. Quand bien même un module d'Young inférieur à 80 MPa entraînerait une légère imprécision du positionnement du capteur 110 relativement au support 130, cette imprécision peut être tolérée dans le cadre de la compensation des défauts d'un système d'imagerie, tant que l'on reste dans la profondeur de champ du système optique considéré. Néanmoins, l'imprécision reste modérée puisque le module d'Young reste supérieur ou égal à 20 MPa. Typiquement, pour un module d'Young compris entre 20 et 80 MPa, et une épaisseur de la couche de colle comprise entre 30 et 150 μm, cette imprécision est de l'ordre de quelques micromètres, valeur généralement inférieure à la profondeur de champ.

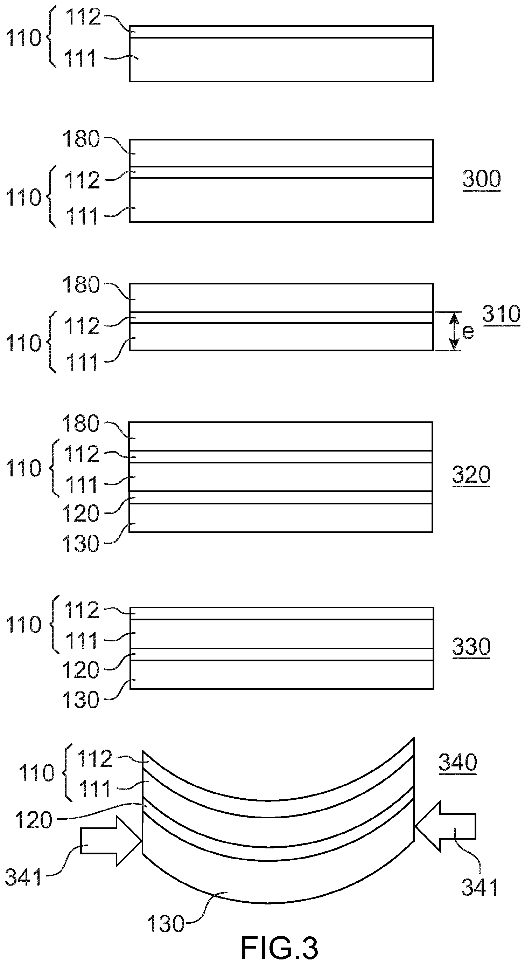

La figure 3 illustre un exemple de procédé de fabrication d'un détecteur optique tel que représenté en figure 1.

Le point de départ de ce procédé de fabrication est une couche de silicium dite « processée », c'est-à-dire présentant une couche active 112 en surface d'un substrat en silicium 111. La couche active et le substrat en silicium forment ensemble un capteur photosensible 110 tel que décrit en référence à la figure 1.

Au cours d'une étape 300, on fixe sur la couche active 112 une couche de substrat 180 tel que du silicium ou du verre. La couche 180 forme une poignée, permettant de manipuler aisément le capteur photosensible 110.

A l'étape 310, on amincit le substrat en silicium de sorte que le capteur photosensible 110 présente après amincissement une épaisseur inférieure ou égale à 150 μm. Cette épaisseur est généralement comprise entre 25 et 150 μm.

A l'étape 320, on colle l'ensemble formé par la couche 180 et le capteur photosensible 110 sur un support 130, par l'intermédiaire d'une couche de colle 120. Le support et la couche de colle sont décrits avec précision en référence à la figure 1. La couche de colle 120 est disposée directement entre une face supérieure du support 130 et une face inférieure du capteur photosensible 110, du côté opposé à la couche active 112. La couche de colle 120 s'étend sur toute la surface du capteur photosensible.

A l'étape 330, on retire la couche 180 formant poignée. Le cas échéant, on ajoute sur le capteur photosensible des filtres, notamment des filtres colorés, et/ou des microlentilles, etc.

Ensuite, au cours d'une étape 340, on déforme le support 130. Cette déformation est contrôlée, c'est-à-dire qu'on maîtrise les caractéristiques de cette déformation, en particulier la forme finale de la face supérieure du support 130, au contact de la couche de colle 120. La déformation contrôlée du support 130 entraîne la même déformation contrôlée du capteur photosensible 110, maintenu solidaire du support sur toute son étendue grâce à la couche de colle 120.

La déformation du support est réalisée en appliquant des contraintes latérales au support, c'est-à-dire des forces orientées dans un plan parallèle au plan du capteur photosensible avant toute déformation. Ces contraintes latérales sont symbolisées par les flèches 341. Par exemple, le support est entouré latéralement par des actionneurs.

En variante, la déformation du support est réalisée à l'aide de cavités en dépression ou en surpression disposées du côté du support opposé à la couche de colle.

Selon une autre variante, la déformation du support est réalisée en maintenant fixes les bords externes du support, et en exerçant des forces de traction ou de compression sur des poignées fixées du côté du support opposé à la couche de colle.

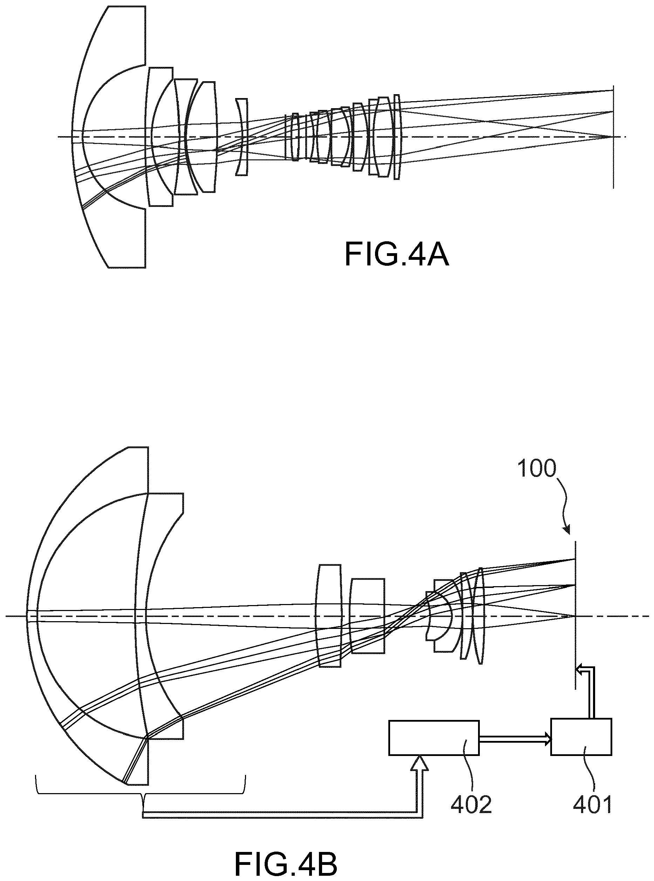

On va maintenant décrire en référence aux figures 4A et 4B une utilisation avantageuse d'un détecteur optique selon l'invention.

La figure 4A illustre un système optique tel que décrit dans la demande de brevet EP 2 407 809. Il s'agit d'un objectif grand angle d'appareil photo, à grandissement variable. L'angle d'incidence en entrée de ce système optique va de -89° à +89°. L'objectif est analysé en particulier pour cinq valeurs de zoom correspondant respectivement à une distance focale de 8,5 mm, 10 mm, 12 mm, 13,5 mm et 14,8 mm, et pour les trois longueurs d'onde 588 nm, 656 nm et 486 nm. On montre qu'il présente d'excellentes performances optiques, notamment en termes de courbure de champ. Ces performances ont néanmoins un coût : ce système optique est composé de 14 lentilles, mettant en œuvre 10 types de verre différents et 2 surfaces asphériques.

La figure 4B illustre une variante du système optique de la figure 4A. Le système optique de la figure 4B comprend seulement 8 lentilles, mettant en œuvre 4 types de verre différents et uniquement des surfaces sphériques. Le système optique de la figure 4B implique donc des coûts de fabrication bien moindres. Le tableau ci-dessous décrit précisément le système optique. Les interfaces du système optique sont numérotées de 1 à 15, de gauche à droite sur la figure 4B. Le matériau correspond à ce qui se trouve à droite de l'interface, en pratique un verre en entrée d'une lentille, de l'air en sortie d'une lentille (sauf à l'interface 10 qui correspond à la fois à l'interface de sortie de la 5ème lentille et à l'interface d'entrée de la 6ème lentille). Les mesures de distance sont positives lorsqu'on se déplace dans le sens des rayons lumineux (de gauche à droite sur la figure 4B), négatives sinon.

Tableau 2 :

| Interface | Rayon de courbure (mm⁻¹) | Epaisseur (mm) | Matériau |
|---|---|---|---|
| 1 | 2,692E-02 | 2,00 | J-LASF015 |
| 2 | 4,189E-02 | 18,80 | Air |
| 3 | 8,868E-03 | 2,00 | J-LASF015 |
| 4 | 3,198E-02 | Variable | Air |
| 5 | 1,659E-02 | 5,00 | SF58 |
| 6 | -7,337E-03 | 1,57 | Air |
| 7 | 1,636E-02 | 6,60 | J-LASF015 |
| 8 | 7,121E-03 | 8,79 | Air |
| 9 | -1,018E-01 | 4,26 | LASFN31 |

(suite)

| Interface | Rayon de courbure (mm$^{-1}$) | Epaisseur (mm) | Matériau |
|---|---|---|---|
| 10 | -2,042E-01 | 2,00 | SF58 |
| 11 | -7,167E-02 | 0,00 | Air |
| 12 | -9,710E-03 | 2,00 | SF58 |
| 13 | -4,124E-02 | 0,00 | Air |
| 14 | 2,945E-02 | 2,21 | P-PK53 |
| 15 | -1,260E-02 | Variable | Air |

Il s'agit également d'un objectif grand angle d'appareil photo, à grandissement variable. La variation du grandissement est réalisée en modifiant la distance entre la deuxième et la troisième lentille (épaisseur de l'interface 4). L'image formée par l'objectif est reçue par un détecteur optique. La position de ce détecteur optique doit être ajustée en fonction du grandissement de l'objectif (épaisseur de l'interface 15).

L'angle d'incidence en entrée de ce système optique va de -89° à +89°. L'objectif est analysé en particulier pour les cinq mêmes distances focales et les trois mêmes longueurs d'onde. On montre qu'il présente d'excellentes performances optiques, tout à fait comparables à celles du système optique de la figure 4A, notamment en ce qui concerne la distorsion, l'aberration sphérique, l'astigmatisme, le chromatisme axial, et le chromatisme longitudinal. En revanche, la courbure de champ est bien supérieure, environ 2,5 fois plus importante. Or, cette aberration peut être corrigée non pas en modifiant le système optique, mais tout simplement en compensant la courbure de champ par une courbure identique du détecteur optique recevant l'image formée par le système optique. Le détecteur optique selon l'invention permet, grâce aux caractéristiques de la couche de colle, d'atteindre facilement des déformations importantes. Il est ainsi possible de corriger facilement et à faible coût des défauts importants d'un système optique d'imagerie. Ainsi, l'invention permet de recourir à des systèmes d'imagerie présentant une forte courbure de champ, et de compenser facilement ce défaut par la forme du détecteur optique. D'autres aberrations optiques telles que l'astigmatisme peuvent être compensées de la même manière. Il n'est cependant pas nécessaire de compenser plus que les aberrations subsistantes telles que le chromatisme, ce qui confère une certaine tolérance sur le positionnement de chaque point de la surface de détection du détecteur optique.

Dans cet exemple particulier, la surface de détection du détecteur optique est déformée en forme de portion de sphère. Le rayon de courbure de cette portion de sphère dépend de la focale de l'objectif, et prend les valeurs suivantes (la variation de focale entraîne une variation du grandissement) :

Tableau 3 :

| Focale | 8,5 mm | 10 mm | 12 mm | 13,5 mm | 14,8 mm |
|---|---|---|---|---|---|
| Rayon de courbure | 638 mm | 255 mm | 180 mm | 166 mm | 200 mm |

D'après le tableau 1, une épaisseur de la couche de colle de 50 μm ou plus permet d'atteindre un rayon de courbure minimal de 166 mm. Ainsi, le détecteur optique selon l'invention peut prendre l'ensemble de ces valeurs de rayons de courbure.

On a représenté en figure 4B, et de façon schématique, le détecteur optique 100 selon l'invention, relié à des moyens de déformation du support 401, eux-mêmes commandés par des moyens d'asservissement 402. Les moyens d'asservissement 402 sont agencés pour piloter en temps réel les moyens de déformation du support 401, en fonction de la focale de l'objectif. Sur la figure 4B, on voit que les moyens d'asservissement 402 reçoivent en entrée une consigne relative à la focale de l'objectif, en particulier la distance entre la deuxième et la troisième lentille. Les moyens d'asservissement relient la consigne relative à la focale de l'objectif, et une consigne relative à la courbure du détecteur optique. La consigne relative à la courbure du détecteur optique est fournie aux moyens de déformation du support 401. Les moyens de déformation du support peuvent être similaires à ce qui a été décrit à propos de l'étape 340, en référence à la figure 3.

Ainsi, la déformation du support, et avec elle la déformation du capteur photosensible, est pilotée en temps réel, selon le principe de l'optique adaptative. La déformation est réversible, et varie en fonction d'une consigne de déformation. La consigne de déformation varie ici en fonction de la focale du système d'imagerie à focale variable situé en amont du détecteur optique.

La déformation du support en temps réel n'est pas nécessaire à la définition de l'invention. En effet, le détecteur optique selon l'invention peut également compenser des défauts d'un système optique d'imagerie à focale fixe. En outre, dans le cas d'un système optique à focale variable, la variation de la focale n'a pas systématiquement un impact sur le défaut de courbure de champ.

On va maintenant décrire un exemple de réalisation particulier, illustrant notamment le fort potentiel de déformation du détecteur optique selon l'invention.

Selon cet exemple, le détecteur optique présente une courbure fixe. La face de la couche active 112, du côté opposé au substrat 11, est un rectangle de 20x10 mm$^2$. Le plus grand côté de ce rectangle définit la largeur du capteur photosensible. La moitié de cette surface supérieure est dédiée à la détection de photons, soit un carré de 10x10 mm$^2$. Ce carré forme la surface de détection. La surface supérieure du capteur photosensible présente une forme de sphère, de rayon de courbure égal à 80 mm. On peut réaliser des variantes de ce mode de réalisation, en utilisant les dimensions indiquées ci-dessus et en leur appliquant une simple homothétie. On conserve ainsi le rapport entre la largeur du capteur photosensible (20 mm) et le rayon de courbure du capteur photosensible (80 mm). Ce rapport est égal à $\frac{1}{4}$. Selon l'invention, ce rapport peut être supérieur ou égal à $\frac{1}{8}$, de préférence supérieur ou égal à $\frac{3}{16}$, voire même $\frac{1}{4}$. On remarque que la déformation étant sphérique, il importe de considérer les dimensions du capteur. A rayon de courbure égal, plus le capteur est grand, plus les contraintes qui s'exercent en ses coins sont importantes.

La surface supérieure du capteur photosensible présente ainsi une déformation dont l'amplitude pic-vallée vaut environ 624 $\mu$m. L'amplitude pic-vallée de la déformation de la surface supérieure du capteur photosensible est la distance, selon un axe (Oz), entre le point de ladite surface supérieure le plus haut selon (Oz), et le point de ladite surface supérieure le plus bas selon (Oz). L'orientation de l'axe (Oz) est choisie de sorte que cette distance soit minimale.

Selon l'invention, cette amplitude pic-vallée est par exemple supérieure ou égale à 300 $\mu$m, et peut être comprise entre 300 $\mu$m et 1 mm. Le rapport entre la largeur du capteur photosensible (20 mm), et cette amplitude (624 $\mu$m), est donc égal à environ 32. Selon l'invention, ce rapport peut être inférieur ou égal à 64, de préférence inférieur ou égal à 48, voire même 32. On préfère parfois utiliser un rapport impliquant une amplitude pic-vallée, en particulier lorsque le capteur photosensible n'a pas la forme d'une simple portion de sphère (sans pour autant avoir une forme de portion de cylindre de révolution).

L'invention n'est pas limitée aux exemples qui viennent d'être décrits, et l'homme du métier saura réaliser de nombreuses variantes sans sortir du cadre de la présente invention. Par exemple, la surface supérieure du capteur photosensible peut présenter une forme asphérique.

## Revendications

1. Détecteur optique (100) à surface de détection courbe comprenant :

   - un capteur photosensible (110) ;
   - un support (130) agencé pour imposer une courbure au capteur photosensible ; et
   - une couche de colle (120), disposée directement entre le capteur photosensible et le support ;
   **caractérisé en ce que** la couche de colle (120) présente une épaisseur supérieure ou égale à 50 $\mu$m.

2. Détecteur optique (100) selon la revendication 1, **caractérisé en ce que** la couche de colle (120) présente une épaisseur comprise entre 50 $\mu$m et 150 $\mu$m, les bornes étant incluses.

3. Détecteur optique (100) selon la revendication 1 ou 2, **caractérisé en ce que** la couche de colle (200) présente un module d'Young compris entre 20 et 80 MPa, les bornes étant incluses.

4. Détecteur optique (100) selon l'une quelconque des revendications 1 à 3, **caractérisé en ce que** le capteur photosensible (110) comprend un substrat (111) en matériau semiconducteur, au contact direct de la couche de colle.

5. Détecteur optique (100) selon la revendication 4, **caractérisé en ce que** le substrat (111) est du silicium.

6. Détecteur optique (100) selon l'une quelconque des revendications 1 à 5, **caractérisé en ce qu'**un rapport entre une largeur du capteur photosensible (110), et un rayon de courbure du capteur photosensible, est supérieur ou égal à $\frac{1}{8}$.

7. Détecteur optique (100) selon l'une quelconque des revendications 1 à 5, **caractérisé en ce qu'**un rapport entre une largeur du capteur photosensible (110), et une amplitude pic-vallée de la surface supérieure du capteur photosensible, est inférieur ou égal à 40.

8. Détecteur optique (100) selon l'une quelconque des revendications 1 à 7, **caractérisé en ce qu'**il comprend des moyens de déformation du support (401), reliés à des moyens d'asservissement (402) agencés pour piloter en temps réel les moyens de déformation du support.

9. Système optique d'imagerie comprenant un détecteur optique (100) selon l'une quelconque des revendications 1 à 8.

10. Procédé de fabrication d'un détecteur optique (100) comprenant les étapes suivantes :

- collage d'un capteur photosensible (110) sur un support (130), à l'aide d'une couche de colle (120), disposée directement entre le capteur photosensible et le support ;
- déformation du support (130), entraînant une déformation du capteur photosensible (110) collé sur le support ;
**caractérisé en ce que** la couche de colle (120) utilisée présente une épaisseur supérieure ou égale à 50 $\mu$m.


**Patentansprüche**

1. Optischer Detektor (100) mit gekrümmter Detektionsfläche, enthaltend:

- einen lichtempfindlichen Sensor (110);
- einen Träger (130), der so angeordnet ist, dass er dem lichtempfindlichen Sensor eine Krümmung vorgibt; und
- eine Klebstoffschicht (120), die direkt zwischen dem lichtempfindlichen Sensor und dem Träger angeordnet ist;
**dadurch gekennzeichnet, dass** die Klebstoffschicht (120) eine Dicke größer oder gleich 50 $\mu$m aufweist.

2. Optischer Detektor (100) nach Anspruch 1, **dadurch gekennzeichnet, dass** die Klebstoffschicht (120) eine Dicke zwischen 50 $\mu$m und 150 $\mu$m einschließlich aufweist.

3. Optischer Detektor (100) nach Anspruch 1 oder 2, **dadurch gekennzeichnet, dass** die Klebstoffschicht (200) einen Elastizitätsmodul zwischen 20 und 80 MPa einschließlich aufweist.

4. Optischer Detektor (100) nach einem der Ansprüche 1 bis 3, **dadurch gekennzeichnet, dass** der lichtempfindliche Sensor (110) ein Substrat (111) aus Halbleitermaterial in direktem Kontakt mit der Klebstoffschicht enthält.

5. Optischer Detektor (100) nach Anspruch 4, **dadurch gekennzeichnet, dass** das Substrat (111) Silizium ist.

6. Optischer Detektor (100) nach einem der Ansprüche 1 bis 5, **dadurch gekennzeichnet, dass** ein Verhältnis einer Breite des lichtempfindlichen Sensors (110) zu einem Krümmungsradius des lichtempfindlichen Sensors größer oder gleich 1/8 ist.

7. Optischer Detektor (100) nach einem der Ansprüche 1 bis 5, **dadurch gekennzeichnet, dass** ein Verhältnis einer Breite des lichtempfindlichen Sensors (110) zu einer Spitze-Tal-Höhe der oberen Fläche des lichtempfindlichen Sensors kleiner oder gleich 40 ist.

8. Optischer Detektor (100) nach einem der Ansprüche 1 bis 7, **dadurch gekennzeichnet, dass** er Mittel zum Verformen des Trägers (401) enthält, die mit Regelungsmitteln (402) verbunden sind, die so angeordnet sind, dass sie die Mittel zum Verformen des Trägers in Echtzeit ansteuern.

9. Optisches Abbildungssystem mit einem optischen Detektor (100) nach einem der Ansprüche 1 bis 8.

10. Verfahren zur Herstellung eines optischen Detektors (100) mit den folgenden Schritten:

**EP 3 093 634 B1**

- Aufkleben eines lichtempfindlichen Sensors (110) auf einen Träger (130) unter Verwendung einer Klebstoffschicht (120), die direkt zwischen dem lichtempfindlichen Sensor und dem Träger angeordnet ist;
- Verformen des Trägers (130), was zu einem Verformen des mit dem Träger verklebten lichtempfindlichen Sensors (110) führt;

**dadurch gekennzeichnet, dass** die verwendete Klebstoffschicht (120) eine Dicke größer oder gleich 50 $\mu$m aufweist.

**Claims**

1. An optical detector (100) with a curved detection area comprising:

   - a photosensitive sensor (110);
   - a support (130) arranged to dictate a curvature to the photosensitive sensor; and
   - a glue layer (120), disposed directly between the photosensitive sensor and the support;
   **characterised in that** the glue layer (120) has a thickness greater than or equal to 50$\mu$m.

2. The optical detector (100) according to claim 1, **characterised in that** the glue layer (120) has a thickness between 50$\mu$m and 150$\mu$m, limits included.

3. The optical detector (100) according to claim 1 or 2, **characterised in that** the glue layer (200) has a Young modulus between 20 and 80MPa, limits included.

4. The optical detector (100) according to any of claims 1 to 3, **characterised in that** the photosensitive sensor (110) comprises a semiconductor material substrate (111), in direct contact with the glue layer.

5. The optical detector (100) according to claim 4, **characterised in that** the substrate (111) is silicon.

6. The optical detector (100) according to any of claims 1 to 5, **characterised in that** a ratio of a width of the photosensitive sensor (110) to a radius of curvature of the photosensitive sensor, is greater than or equal to ⅛.

7. The optical detector (100) according to any of claims 1 to 5, **characterised in that** a ratio of a width of the photosensitive sensor (110), and a peak-valley amplitude of the upper surface of the photosensitive sensor, is lower than or equal to 40.

8. The optical detector (100) according to any of claims 1 to 7, **characterised in that** it comprises deformation means (401) for deformation of the support, connected to servoing means (402) arranged to drive the deformation means for deformation of the support in real time.

9. An imaging optical system comprising an optical detector (100) according to any of claims 1 to 8.

10. A method for manufacturing an optical detector (100) comprising the following steps:

    - gluing a photosensitive sensor (110) onto a support (130), using a glue layer (120), disposed directly between the photosensitive sensor and the support;
    - deforming the support (130), leading to a deformation of the photosensitive sensor (110) glued onto the support;
    **characterised in that** the glue layer (120) used has a thickness greater than or equal to 50$\mu$m.

FIG.1

FIG.2

FIG.3

FIG.4A

FIG.4B

**RÉFÉRENCES CITÉES DANS LA DESCRIPTION**

**Documents brevets cités dans la description**

- US 6849843 B
- US 6791072 B1
- EP 2407809 A